# EUROPEAN PATENT APPLICATION

(11) **EP 1 587 020 A1**
(43) Date of publication of application: **19.10.2005**
(21) Application number: 04008887.4
(22) Date of filing: 14.04.2004
(51) Int. Cl.: G06K 7/00, G06F 1/16, H04M 1/00, H05K 5/02, H01R 9/00, G06F 13/40

(54) **Adapter for interface card**

(71) Applicant: AboCom Systems, Inc., Hsinchu City, Taiwan (TW)
(72) Inventor: Wen-Jiunn, Tsay, Hsinchu (TW); Cheng-yu, Wang, Hsinchu (TW); Cheng-Yen, Lin, Hsinchu (TW)
(74) Representative: Winter, Brandl, Fürniss, Hübner Röss, Kaiser, Polte Partnerschaft Patent- und Rechtsanwaltskanzlei

(57) **Abstract**

Disclosed is a converter for interface card (8,7) comprising a casing (11,12) and a circuit board (2). The casing encapsulates the circuit board. The circuit board (2) is provided with a connector (3,5) at one end (2A) to be connected to a connector slot of a first interface protocol provided in a computer and a slot connector (4,6) at the other end (2B) to be connected by a connector of a second interface protocol of an interface card (8,7). The circuit board (2) is also provided with necessary wires and electronic components, to provide exchange of signals and electricity between a plurality of pins of said connector and a plurality of pins of said slot connector. The connector (3,5) and the casing portion adjacent to said connector form a first size and the slot connector (4,6) and the casing portion adjacent to said slot connector define a space of a second size. In one embodiment of this invention, the first size is smaller than the second size, while in another embodiment, the first size is greater than the second size.

## Description

### FIELD OF THE INVENTION

The present invention pertains to a converter for interface card, especially to a converter applicable to interface card with new communication interface, such as the ExpressCard interface.

### BACKGROUND OF THE INVENTION

In the application of the computer products, most peripheral devices, except those already integrated into the computer system, need to connect with the computer system or other peripherals with an interface card, such that the peripheral devices may communicate with the computer system or other peripherals through the communication interface to provide necessary functions.

An ordinary interface card in general comprises: a casing, a circuit board and a converter. The converter is provided at one side of the circuit board. The circuit board is also provided with necessary electronic components. At the other side of the circuit board provided is connector-wire, which wire is connected to the peripheral device. Here, the wire may be a cable, a flexible flat cable, and other signal wire or power cord. If the wireless technology is applied, the other side of the circuit board is provided with a wireless transceiver to communicate with particular peripheral or a network node.

The most significant limitation in the design of the interface card rests in the fact that all types of interface card are designed according to particular interface protocols. Generally speaking, the major differences among interface protocols are the thickness and width of the interface card, and the pin count, the pin arrangement and the pin pitch of the interface card. As a result, an interface card that is designed based on one particular interface protocol does not fit the standard of other interface protocols.

Due to the development of the computer technology, new interface protocols are announced from time to time. The most recently announced interface protocol of "ExpressCard" has been accepted in the industry. Many have announced interface cards following this new protocol. At the same time, computer or mother board makers also started to produce products equipped with slots complying with new interface protocols. As a result, interface cards of an old interface protocol, such as the Card Bus standard, can not be used with a computer that simply provides connector slots of new interface protocols, such as the ExpressCard standard. An additional interface card of the new protocol is necessary for the device connected with the interface card of the old interface protocol in order to work with that computer. On the other hand, a device connected with an interface card of the new interface protocol does not work with an old type computer, without connecting to an additional interface card of any of the old interface protocols. Portability of the interface card is thus damaged.

### OBJECTIVES OF THE INVENTION

The objective of this invention is to provide a converter for interface card to facilitate communications between interface card and connector slot of different interface protocols.

Another objective of this invention is to provide a novel converter for interface card to enable the normal operation of the interface card with both old and new interface protocols.

Another objective of this invention is to provide a converter for interface card to eliminate the necessity of providing separate additional interface cards for a device to work with two different interface protocols.

### SUMMARY OF THE INVENTION

According to this invention, the converter for interface card comprises a casing and a circuit board. The casing encapsulates the circuit board. The circuit board is provided with a connector at one end to be connected to a connector slot of a first interface protocol provided in a computer and a slot connector at the other end to be connected by a connector of a second interface protocol of an interface card. The circuit board is also provided with necessary wires and electronic components, to provide exchange of signals and electricity between a plurality of pins of said connector and a plurality of pins of said slot connector. The connector and the casing portion adjacent to said connector form a first size and the slot connector and the casing portion adjacent to said slot connector define a space of a second size. In one embodiment of this invention, the first size is smaller than the second size, while in another embodiment, the first size is greater than the second size.

These and other objectives and advantages of this invention may be clearly understood from the detailed description by referring to the following drawings.

### BRIEF DESCRIPTION OF THE DRAWINGS

Fig. 1 shows the structure of the first embodiment of the converter for interface card of this invention.
Fig. 2 shows the structure of the second embodiment of the converter for interface card of this invention.

### DETAILED DESCRIPTION OF THE INVENTION

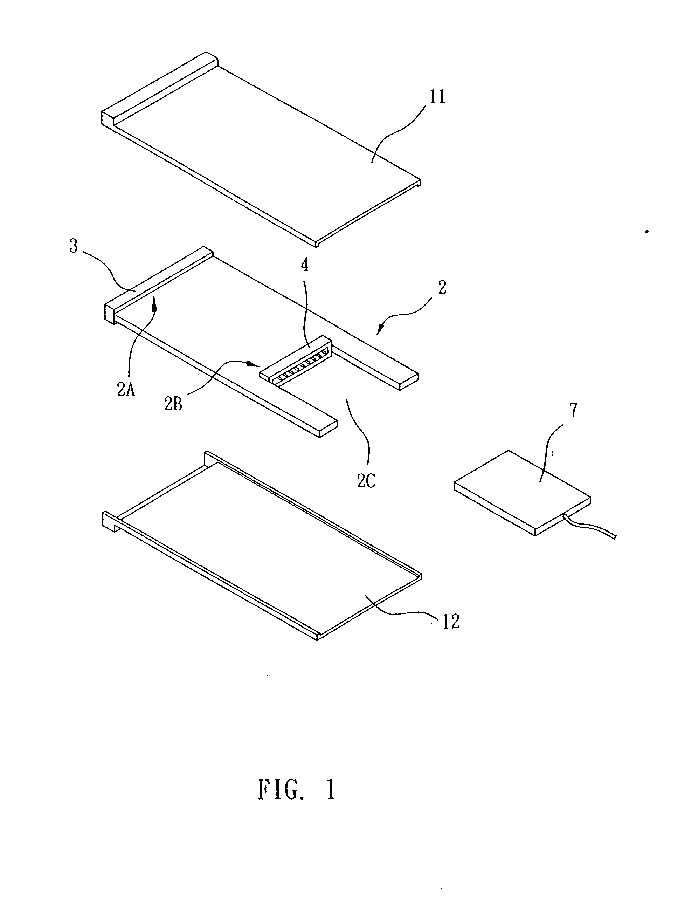

The present invention provides a converter for interface card to facilitate communications between interface card and connector slot of different interface protocols. Fig. 1 shows the structure of the first embodiment of the converter for interface card of this invention.

As shown in this figure, the converter for interface card comprises an upper cover 11, a lower cover 12 and a circuit board 13. The upper cover 11 and the lower cover 12 may be assembled to form a casing to encapsulate the circuit board 13. The upper cover 11, the lower cover 12 and the circuit board 13 preferably have corresponding shapes.

The converter for interface card as shown in Fig. 1 is designed to work with an interface card 7 of the "ExpressCard" interface protocol and the connector slot of the "Card Bus" interface protocol (not shown) provided in a computer. According to the current protocols, the width of the ExpressCard is 34 mm and the width of the Card Bus slot is 54 mm.

The circuit board 13 is provided with a connector 3 at one end 2a. The connector 3 serves to be inserted into a first interface connector slot (not shown) provided in a computer. For this purpose, the width of the connector 3 and the portions of the upper cover 11 and the lower cover 12 adjacent to the connector 3, after assembly, is preferably the width of a Card Bus interface card connector, i.e. 54 mm. A slot connector 4 is provided at the other end 2b of the circuit board 2. The slot connector 4 serves to be connected by the interface connector of the ExpressCard interface card 7. For this purpose, the width of the space defined by the slot connector 4 and the portions of the upper cover 11 and the lower cover 12 adjacent to the connector slot 4, after assembly, is preferably the width of an ExpressCard connector slot, i.e. 34 mm. This size allows the ExpressCard 7 to be inserted to the space to connect with the slot connector 4. In this figure, an indentation 2c is formed at end 2b of the circuit board 2 where the connector 4 locates, whereby the swapping activity of the ExpressCard interface card 7 to and from the slot connector 4 is made easier and the ExpressCard 7 is firmly held by the converter after being inserted. Of course, this invention applies to where no indentation is provided in the circuit board 2. In addition, the upper cover 11 and the lower cover 12 may have or not have a corresponding indentation at this end.

A plurality of connector pins (not shown) is provided in the connector 3 and the slot connector 4. Necessary wires and electronic components (both not shown) are provided in the circuit board 2, to connect the plurality of pins of the connector 3 and the plurality of pins of the slot connector 4, so to allow signal and electricity exchange between the pluralities of pins.

Assemble the upper cover 11, the lower cover 12 and the circuit board 2 to form a converter. Insert the connector pins of the ExpressCard 7 into the slot connector 4 and insert the connector 3 into the corresponding connector slot of a computer. It is thus possible to use the peripheral connected to the EspressCard 7 with a computer where no ExpressCard interface slot is not provided.

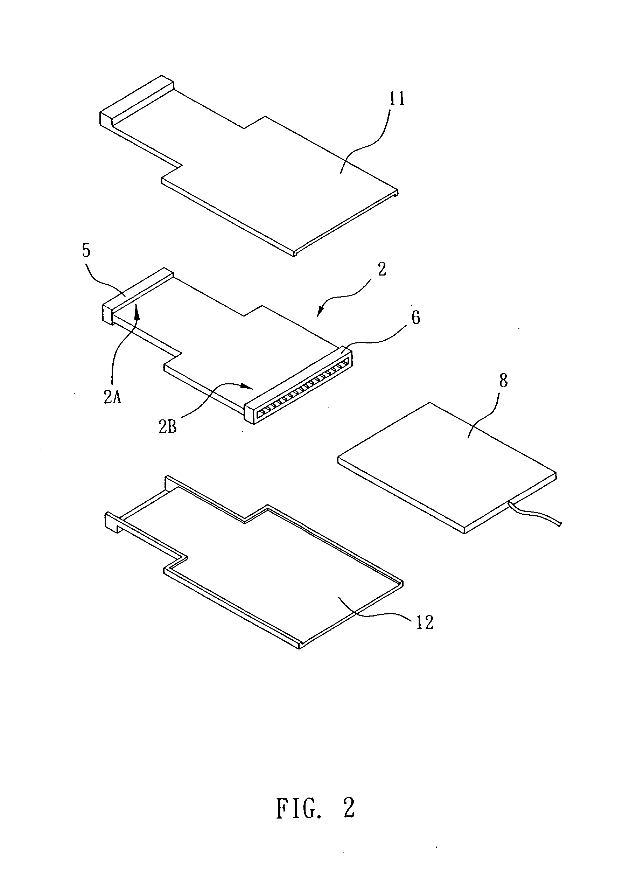

Fig. 2 shows the structure of the second embodiment of the converter for interface card of this invention. Components that are the same with that of Fig. 1 are labeled with the same numbers. As shown in this figure, the converter for interface card of this embodiment is designed to work with an interface card 8 of the "Card Bus" interface protocol and the connector slot of the "ExpressCard" interface protocol (not shown) provided in a computer.

As shown in this figure, the converter for interface card also comprises an upper cover 11, a lower cover 12 and a circuit board 13. The upper cover 11 and the lower cover 12 may be assembled to form a casing to encapsulate the circuit board 13.

A connector 5 is provided at an end 2a of the circuit board 2, to be connected with an ExpressCard slot provided in a computer. To achieve this goal, the portion of the circuit board 2 and the portions of the upper cover 11 and the lower cover 12, all adjacent to the connector 5, preferably have a width of 34 mm after assembly. A slot connector 6 is provided at the other end 2b of the circuit board 2, to be connected by the connector of the Card Bus interface card 8. To achieve this goal, the portion of the circuit board 2 and the portions of the upper cover 11 and the lower cover 12, all adjacent to the slot connector 6, preferably have a width of 54 mm after assembly. In order to firmly hold the Card Bus interface card 8, the length of the upper cover 11 and the lower cover 12 is preferably longer than that of the circuit board 2, so to surround the interface card 8 after it is inserted. However, this is not any necessary requirement of the converter.

The converter for interface card as described above may have a thicker end and a thinner end. The thickness and the width of the thicker end are greater than that of the thinner end. The converter so fabricated may be inserted into the ExpressCard interface slot of a computer after a Card Bus interface card 8 is connected to its slot connector 6, such that a peripheral device that is connected to the Card Bus interface card may function with the computer where only ExpressCard interface slot is provided.

As described above, the converter for interface card of this invention comprises a casing and a circuit board. The casing encapsulates the circuit board. The circuit board is provided with a connector at one end to be connected to a connector slot of a first interface protocol provided in a computer and a slot connector at the other end to be connected by a connector of a second interface protocol of an interface card. The circuit board is also provided with necessary wires and electronic components, to provide exchange of signals and electricity between a plurality of pins of said connector and a plurality of pins of said slot connector. The connector and the casing portion adjacent to said connector form a first size and the slot connector and the casing portion adjacent to said slot connector define a space of a second size. In one embodiment of this invention, the first size is smaller than the second size, while in another embodiment, the first size is greater than the second size.

When using the converter for interface card of this invention, it is not necessary to prepare an additional type of interface card, in order to allow an ExpressCard interface card to work with a computer where no ExpressCard interface slot is provided, or to allow a peripheral which is not provided with an ExpressCard interface card to work with a computer where only the ExpressCard interface slot is provided.

In the application of this invention, the two embodiments of this invention may be connected by inserting one into the other to form a set product. The user may use the set product with peripherals and computer where interface cards or interface slots with different interface protocols are provided. No additional types of interface card are necessary.

As the present invention has been shown and described with reference to preferred embodiments thereof, those skilled in the art will recognize that the above and other changes may be made therein without departing form the spirit and scope of the invention.

## Claims

1. A converter for interface card, comprising a casing and a circuit board being encapsulated by said casing;
wherein said circuit board comprises:
a connector at one end to be connected to a connector slot of a first interface protocol provided in a computer;
a slot connector at the other end to be connected by a connector of a second interface protocol of an interface card; and
wires and electronic components to provide exchange of signals and electricity between a plurality of pins of said connector and a plurality of pins of said slot connector;
wherein said connector and casing portion adjacent to said connector form a first size and said slot connector and casing portion adjacent to said slot connector define a space of a second size.

2. The converter for interface card according to claim 1, wherein said first size is smaller than said second size.

3. The converter for interface card according to claim 1, wherein said first size is greater than said second size.

4. The converter for interface card according to claim 1, wherein said first size is size of an ExpressCard standard connector and said second size is size to accept connector of a Card Bus standard interface card.

5. The converter for interface card according to claim 1, wherein said first size is size of a Card Bus standard connector and said second size is size to accept connector of an ExpressCard standard interface card.

## Amended claims

### Amended claims in accordance with Rule 86(2) EPC.

**1.** A converter for interface card, said converter comprising a casing and a circuit board being encapsulated by said casing;
wherein said circuit board comprises:
a connector at one end to be connected to a connector slot of a first interface protocol provided in a computer;
a slot connector at the other end to be connected by a connector of a second interface protocol of an interface card; and
wires and electronic components to provide exchange of signals and electricity between a plurality of pins of said connector and a plurality of pins of said slot connector;
wherein said connector and casing portion adjacent to said connector form a firs size and said slot connector and casing portion adjacent to said slot connector define a space of a second size, **characterized in that** on of said first and second size is size of an ExpressCard standard connector.

**2.** The converter for interface card according to claim 1, wherein said first size is smaller than said second size.

**3.** The converter for interface card according to claim 1, wherein said first size is greater than said second size.

**4.** The converter for interface card according to claim 1, wherein the other of said first and second size is size to accept connector of a Card Bus standard interface card.
